# EUROPEAN PATENT SPECIFICATION

(11) **EP 0 330 698 B1**
(45) Date of publication and mention of the grant of the patent: **19.01.1994**
(21) Application number: 88908036.2
(22) Date of filing: 18.07.1988
(51) Int. Cl.: C01G 33/00, C01G 35/00

(54) **PROCESS FOR PURIFYING (Nb1-xTax)2O5 AND THE PREPARATION OF KNb1-xTaxO3-CRYSTALS THEREFROM**
VERFAHREN ZUR REINIGUNG VON (Nb1-xTax)2O5 UND DIE HERSTELLUNG VON KNb1-xTaxO3-KRISTALLEN
PROCEDE POUR PURIFIER DU (Nb1-xTax)2O5 ET PREPARATION DE CRISTAUX DE KNb1-xTaxO3 A PARTIR DE CE COMPOSE

(30) Priority: 27.08.1987 US 89808
(43) Date of publication of application: 06.09.1989
(73) Proprietor: Hughes Aircraft Company, Los Angeles, California 90045-0066 (US)
(72) Inventor: KYLE, Nanse, R., Topanga, CA 90290 (US)
(74) Representative: KUHNEN, WACKER & PARTNER
(86) International application number: US8802371
(87) International publication number: WO8901914

(56) References cited:
- EP-A- 0 070 642
- EP-A- 0 241 278
- EP-A- 0 251 432
- GB-A- 1 149 492
- US-A- 4 164 417
- Chemical Abstract, volume 96, no. 18, 3 May 1982, (olumbus, Ohio, US), see page 158, abstract 145409g, & SU, A, 891567 (INSTITUTE OF CHEMISTRY AND TECHNOLOGY OF RARE ELEMENTS AND MINERAL RAW MATERIALS, APATITY) 13 January 1982
- Journal of the American Ceramic Society, volume 49, no. 8, 1966, W.R. Wilcox et al.: "Growth of KTaO3-KNbO3 mixed crystals", pages 415-418, see page 415, right-hand column, paragraph 3 - page 416, left-hand column, paragraph 3
- Chemical Abstracts, volume 99, no. 16, 17 October 1983, (olumbus, Ohio, US), A.I. Nikolaev et al.: "Thermal method for the removal of impurities from niobium and tantalum hydroxides", see page 135, abstract 124936y, & Zh. Prikl. Khim. (Leningrad) 1983, 56(7),1631-4

## Description

This invention relates to purification processes for removing impurities from compounds and the preparation of crystals from such compounds, and, more particularly, to a process for purifying (Nb₁₋ₓTaₓ)₂O₅ and preparing crystals therefrom.

High purity, nearly perfect single crystals are used in a wide variety of electronic, optical, electro-optical, and other applications because of particular properties found in such single crystals of selected compositions. In some cases, the single crystals are prepared by first providing a precursor material in a highly purified form, and then transforming the pure precursor material into a single crystal of the composition desired.

A technologically important example is found in the precursor material M₂O₅, where M is (Nb₁₋ₓTaₓ), with x varying from 0 to 1. When x is 0, the precursor material is Nb₂O₅, which can be transformed to single crystals of KNbO₃. When x is 1, the precursor material is Ta₂O₅, which can be transformed to single crystals of KTaO₃. When x is between 0 to 1, the precursor material is (Nb₁₋ₓTaₓ)₂O₅, also known as NTO, which can be transformed to single crystals of intermediate composition KNb₁₋ₓTaₓO₃, also known as KTN. These single crystals are used in electro-optical applications, wherein the refractive index of the crystal can be altered by application of an electric field, and can be used to sense heat through the pyroelectric effect.

The performance of the single crystals prepared by this approach is heavily dependent upon the types and amounts of impurities in the precursor material. To cite two particular examples, metal-ion impurities having at least two stable valence states, such as elements in the 3d period of the periodic table, can play the role of electron donors or acceptors. Impurities with one stable valence state that is not matched in valence to the host constituent for which they substitute cause charge compensation processes. Color centers can result from these processes, which adversely affect the optical crystal, and increase or decrease the electrical conductivity of the crystal.

An important feature of the preparation of single crystals of these types is therefore the reduction of the impurity contents, particularly for those impurity elements that interfere with the properties of the crystals. A number of approaches hve been tried for reducing the impurity levels, but none have proved sufficiently effective for general use in preparing such crystals. The prior techniques for purification have generally been maintained proprietary by powder manufacturers. There have been no powders available having total impurity contents of less than about 200 parts per million, an impurity level that can have significant adverse effect on the final crystal properties. In one known technique, (Nb₁₋ₓTaₓ)₂O₅ has been purified as the acid, a term used to describe the hydrated oxide H(Nb₁₋ₓTaₓ)O₃·yH₂O. The acid is obtained from ore by alkaline fusion followed by boiling. The acid is precipitated out during hydrolysis. This highly dispersed material is purified of various impurities in a series of tedious procedures wherein one or a few impurities at a time are removed. For example, tin and antimony are removed by digesting the precipitated acid with ammonium sulfide solution. Tungsten is extracted by digestion with dilute ammonia or ammonium carbonate, or by digesting with warm sodium hydroxide solution and boiling with an excess of ammonium nitrate. Silica is removed with hydrofluoric and sulfuric acids. Titanium is removed by adding an excess of salicylic acid and boiling in a reflux condenser, followed by filtration and precipitation of the titanium with ammonia. Zirconium is separated by fusion with bisulfate, the melt being extracted with dilute sulfuric acid to dissolve the zirconium sulfate. After purification, ignition of the purified acid yields (Nb₁₋ₓTaₓ)₂O₅.

In another approach that is believed to be the principal commercial technique at the present time, hydrolysis of a purified pentachloride (Nb₁₋ₓTaₓ)Cl₅ produces a purified acid, which is converted to the oxide by a process like that just described. While the oxide produced in this manner is thought to have the greatest purity available commercially, it still contains a number of impurities, particularly the 3d elements and halides introduced in processing, in concentrations of 200 parts per million or greater, that adversely affect the electronic and optical properties of the KTN single crystals produced therefrom. A technique of repeated rinsing in nitrates can reduce the halide content, but halides and metallic species remain. No method has been proposed for reducing the harmful impurities to acceptably low levels. Accordingly, there exists a need for an effective, economical process for removing impurities from single crystal precursor materials of the type (Nb₁₋ₓTaₓ)₂O₅. The present invention fulfills this need, and further provides related advantages.

EP-A-024178 discloses high purity NTO.

EP-A-0251432 mentions a tantalum pentoxide presenting less than 10 ppm chlorides.

EP-A-70642 discloses the removal of fluoride anions from Ta(OH)₅. Chemical Abstracts, vol. 96, no. 18, 3 May 1982, page 158, Abstract 145409g and SU-A-891567 discloses the removal of impurities with a decreased loss of metals by calcining Nb(OH)₅ and Ta(OH)₅ in the presence of steam. JACS vol.49, no.8, 1966, pages 415 - 418 discloses growing KTN crystals from NTO.

### SUMMARY OF THE INVENTION

The present invention is embodied in a treatment for (Nb₁₋ₓTaₓ)₂O₅ precursor materials, which is effective in removing impurities from the material prior to its use in preparing single crystals or compacts to be processed into single crystals, and in the completed powder and crystals made therefrom. The purification process requires only a single step to complete, does not utilize exotic, dangerous or expensive chemicals, and is performed with readily available, inexpensive equipment. The process is not physically or chemically dangerous to personnel, and does not require expensive scrubbers or other waste control apparatus. The purified (Nb₁₋ₓTaₓ)₂O₅ precursor material is processed into powders or single crystals of KNb₁₋ₓTaₓO₃ that are useful in electronic, optical, and electro-optical applications. The purification process is highly effective in removing harmful impurities from the oxide, so that the resulting crystals are much purer and have better physical properties than crystals prepared from the previously available precursor materials of lower purity.

In accordance with this invention, a process for purifying oxides of the form (Nb₁₋ₓTaₓ)₂O₅, where x ranges from 0 to 1 by removing nearly all impurities including the most harmful metallic and halide impurities, comprises the steps of furnishing the (Nb₁₋ₓTaₓ)₂O₅ in a finely divided form, heating the finely divided (Nb₁₋ₓTaₓ)₂O₅ to a temperature of at least 600° C and passing water vapor over the heated, finely divided (Nb₁₋ₓTaₓ)₂O₅, thereby removing impurities therefrom. Preferably, the water vapor is transported to the finely divided (Nb₁₋ₓTaₓ)₂O₅ in a mixture with an inert carrier gas such as nitrogen. The reaction of the water vapor and the oxide is preferably accomplished with the oxide in a boat within a furnace tube, maintained at a temperature of at least 600°C, preferably from about 900°C to about 1100°C, and most preferably about 1000°C.

In a preferred embodiment, a process for purifying oxides of the form (Nb₁₋ₓTaₓ)₂O₅, where x ranges from 0 to 1, comprises the steps of furnishing the (Nb₁₋ₓTaₓ)₂O₅ in a finely divided form, placing the (Nb₁₋ₓTaₓ)₂O₅ into a container in a tube, heating the (Nb₁₋ₓTaₓ)₂O₅ to a temperature of from about 900°C to about 1100°C, and passing a mixture of water vapor in a carrier gas through the tube and over the (Nb₁₋ₓTaₓ)₂O₅, thereby removing impurities from the (Nb₁₋ₓTaₓ)₂O₅. The preferred carrier gas is nitrogen, and the preferred temperature of reaction is 1000°C. In this treatment, the impurity halides are volatile and are removed in the gas stream. A portion of the niobium and tantalum halides are volatile and are removed in the gas stream. Another portion of the niobium and tantalum halides, however, are converted to their oxides, which are not volatile and remain as the desired species. Oxyhalide impurities react with water to release the volatile halides and metal ions.

The product that results from the process of the invention is still (Nb₁₋ₓTaₓ)₂O₅ in a finely divided form, as the treatment neither changes the basic chemistry of the material nor causes it to sinter to an agglomerated form. The material is not contaminated by any reactants or reaction products. The water is volatile and is removed from the oxide by the gas stream. The reaction products containing the impurities, primarily chlorides, are volatile at the reaction temperature and are also removed from the vicinity of the oxide by the gas stream. NTO materials over the full range of x values may be treated by the process of the invention, from x of zero (Nb₂O₅), including intermediate values of x, and finally to x of 1 (Ta₂O₅).

The treated material has significantly reduced levels of nearly all impurities, including the most harmful metallic and halide impurities, as will be reported in detail in the examples given herein. Total impurity levels of less than 100 parts per million and less than 50 parts per million are routinely reached in the (Nb₁₋ₓTaₓ)₂O₅ and the final KNb₁₋ₓTaₓO₃ crystals, while levels of less than 15 parts per million and even less than 5 parts per million are often reached. By contrast, the lowest impurity levels previously available commercially are about 200 parts per million or more. The high levels of impurities are present in the best, most pure NTO now available commercially, as the prior purification treatments could not remove them to the level achieved by the process of the invention. Thus, it is believed that the pure, finely divided (Nb₁₋ₓTaₓ)₂O₅ prepared by the process of the invention is unique and cannot be prepared in any other manner.

The finely divided (Nb₁₋ₓTaₓ)₂O₅ is then used to prepare crystals of KNb₁₋ₓTaₓO₃. In accordance with this aspect of the process of the invention, a process for preparing highly pure crystals of KNb₁₋ₓTaₓO₃ comprises the steps of furnishing the finely divided (Nb₁₋ₓTaₓ)₂O₅ precursor material having an impurity content of less than about 100 parts per million, by any of the processes of the invention,
placing the (Nb₁₋ₓTaₓ)₂O₅ into a crucible, adding potassium carbonate, and melting the composition of finely divided powder plus potassium carbonate for producing a melt of KNb₁₋ₓTaₓO₃;
touching a seed crystal to the surface of the melt; and
withdrawing the seed crystal upwardly to form a highly pure crystal of KNb₁₋ₓTaₓO₃ thereupon. Such processing is preferably accomplished by a mass gradient-mass transfer technique of pulling the crystal from a melt. The technique will be described in more detail below.

The resulting crystals of KNb₁₋ₓTaₓO₃ exhibit substantially lower impurity levels of damaging impurities and substantially better physical properties than crystals made from commercially available precursor material that has not been treated using the present invention, as will be discussed in more detail in relation to the examples presented herein. It is believed that the improved performance results from the reduced levels of impurities in the precursor materials treated in accordance with the invention. No other approach for obtaining these improved properties in the KNb₁₋ₓTaₓO₃ crystal is known.

In accordance with this aspect of the invention, a high purity KNb₁₋ₓTaₓO₃ material comprises KNb₁₋ₓTaₓO₃ having a total impurity content of less than about 100 parts per million, where x is from 0 to 1, inclusive and is obtainable according to the process disclosed above. Similar materials having less than about 50 parts per million, less than about 15 parts per million, and less than about 5 parts per million are also possible.

It will be appreciated that the processes and purified materials of the present invention present an important advance in the art of making NTO and KTN type materials. The process uses available apparatus and an inexpensive, safe chemical reactant, water. The resulting precursor material and crystals produced therefrom exhibit lower impurity levels and better properties than heretofore available. Other features and advantages will be apparent from the following more detailed description, taken in conjunction with the accompanying drawings, which illustrate, by way of example, the principles of the invention.

### BRIEF DESCRIPTION OF THE DRAWINGS

Figure 1 is a diagrammatic side elevational view of an apparatus for purifying precursor oxide material, with portions broken away for clarity; and
Figure 2 is a side elevational view of an apparatus for growing KTN single crystals.

### DETAILED DESCRIPTION OF THE PREFERRED EMBODIMENT

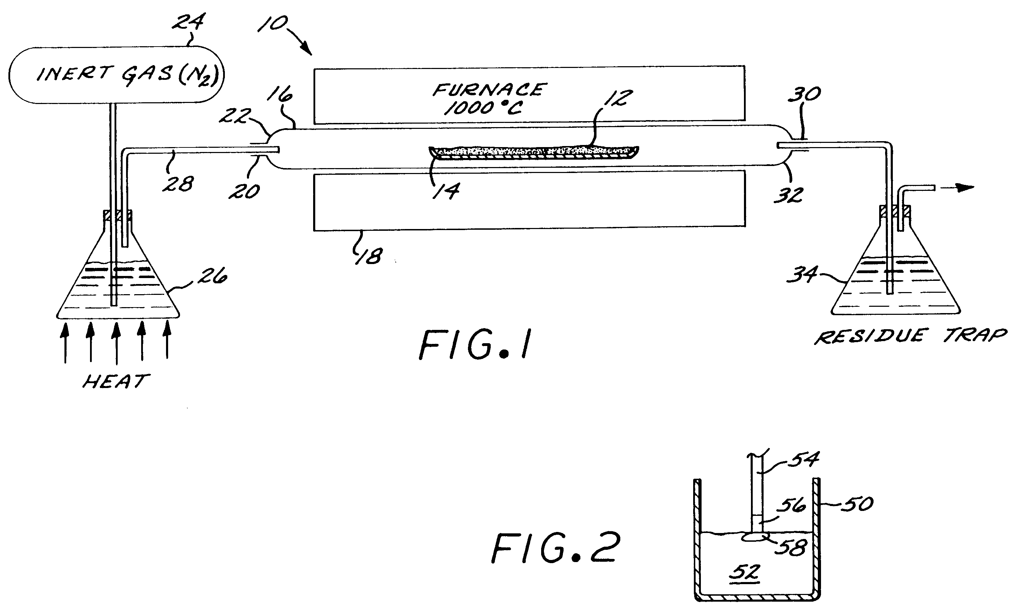

The preferred purification process of the present invention may be used in conjunction with a purification apparatus such as that indicated in Figure 1 by the numeral 10. A mass 12 of finely divided (Nb₁₋ₓTaₓ)₂O₅ oxide powder is placed into a suitable container, such as a boat 14 made of silica. It is desirable that the powder be as finely divided as reasonably possible, at least 15 microns (600 mesh) or smaller, to maximize the amount of contact surface area per unit volume of the oxide. The process is operable with coarser oxide powder, but the purification reaction takes longer. For the same reason, it is desirable that the boat 14 be sufficiently large that the powder mass 12 can be spread out in the boat 14, again to maximize contact area with the gaseous reactant.

The boat 14 is placed within furnace tube 16, made of a heat resistant material such as silica. The furnace tube 16 in turn is placed within a furnace 18 capable of operating at the required reaction temperature. Other heating approaches can be used, but a furnace is preferable because of the generally long reaction period required, and the ability of the furnace to maintain its temperature economically over the reaction period. The furnace is heated to a temperature of from about 900°C to about 1100°C. If lower temperatures are used, the compounds containing the metallic impurities may not be volatile, and the reaction kinetics are so slow that prohibitively long times are required. If higher reaction temperatures are used, the preferred silica furnace tube 16 will devitrify. The middle temperature within the range, 1000°C, is preferably used to provide a short reaction time to achieve a desired level of impurity reduction, without shortening the life of the furnace tube 16 appreciably. Higher temperatures could be used if a more heat-resistant furnace tube is available.

The reaction gas is introduced into the furnace tube 16 through a nipple 20 at a first end 22 of the tube 16. The reaction gas stream includes water vapor as a proton donor. Water vapor is preferred because it is inexpensive, readily available, and physically and chemically safe to use. The water vapor is introduced by passing nitrogen gas from a nitrogen gas source 24 into a bubbler 26 containing water. The bubbler 26 may be heated to increase the vapor pressure of the water. Nitrogen bubbles passing through the heated water absorb some of the water vapor to form a gas mixture. The gas mixture flows to the furnace tube 16 through a gas introduction line 28 connected to the nipple 20.

The gaseous mixture of carrier gas and water vapor passes through the furnace tube 16, flowing over and contacting the hot powder mass 12 in the boat 14. The water vapor reacts with the impurities in the oxide powder. Any unreacted water vapor and the gaseous reaction products are carried with the gas stream out of the furnace tube 16 through a nipple 30 at a second end 32 of the tube 16. The gas stream passes to a second bubbler 34, in which the gas is bubbled through cool water. The purpose of this bubbler 34 is to remove both soluble and insoluble reaction products from the gas stream into the water, as a residue, so that the gas emerging from the bubbler 34 can be exhausted directly to the atmosphere without the necessity of using expensive exhaust cleanup apparatus such as scrubbers, precipitators, and the like, an important advantage in commercial operations.

In the most preferred embodiment of the invention using the apparatus 10, about 500 grams of 15 microns (600 mesh) oxide powder is loaded into a quartz boat 14 about 30 centimeters long and about 6 centimeters wide. The boat 14 is placed into an 8 centimeter diameter furnace tube 16. The water in the bubbler 26 is gently heated to a temperature of about 60°C, and a nitrogen gas stream is started at a flow rate of 10 cubic centimeters per minute. The furnace is heated to a temperature of about 1000°C, with the gas flow on. The gas flow continues for a period of about 14 days, during which the water vapor in the gas mixture reacts with the impurities in the oxide to purify the powder.

At the end of the reaction period, the purified oxide powder is removed from the furnace. The powder generally has the same consistency and powder size as prior to purification, as there is little or no sintering at 1000°C. However, its impurity content is substantially reduced, as compared with the starting material.

Although not wishing to be bound by this possible explanation, it is believed that the proton donor, water in the preferred embodiment, reacts with the chlorides of niobium and tantalum, present as the result of the incomplete hydrolysis of the metal chlorides, to produce hydrogen chloride gas and the metal oxides. The presence of hydrogen chloride gas has been experimentally confirmed. The hydrogen chloride gas in turn reacts with the impurity metals to produce volatile chlorides that are removed in the gas stream. Oxychlorides of niobium and tantalum, which are not volatile at the reaction temperatures, react with the proton donor to form hydrogen chloride gas and the corresponding metal oxide.

The powder is then used as a precursor material and is processed into a crystal of KNb₁₋ₓTaₓO₃ by the following procedure and using the apparatus of Figure 2. A platinum crucible 50 is placed into a resistance furnace (not shown) in air. Fifteen hundred grams of the purified powder prepared by the process just described, plus purified potassium carbonate, is melted into the platinum crucible 50 to form a melt 52. A puller rod 54, having a seed crystal 56 attached thereto, is lowered down to the surface of the melt 52 so that the seed crystal 56 just touches the surface of the melt 52. The seed crystal 56 is typically prepared from a prior run, and can have any desired orientation. Crystals having orientations of <100>, <110>, and <111> are routinely used. The puller rod 54 is gradually drawn upwardly, at a slow rate of about 1 millimeter per day, so that a crystal 58 is formed where the tip of the seed crystal 56 touches the surface of the melt 52. Crystals of about 200-300 grams size are readily prepared by this method.

A variation of this technique, wherein the composition of the melt is controlled, is disclosed in the publication "A Constant Temperature Method for the Growth of KTN Single Crystals," by A.L. Gentile and F.H. Andres, in Materials Research Bulletin, Vol. 2, pages 853-859, 1967, which disclosure is herein incorporated by reference. Another operable technique is discussed in "Growth of High-Quality Crystals of KTN," by P.W. Whipps, in Journal of Crystal Growth, Vol. 12, pages 120-124, 1972, and yet another is disclosed in "Growth of KTaO₃-KNbO₃ Mixed Crystals," by W.R. Wilcox and L.D. Fullmer, in the Journal of the American Ceramic Society, Vol. 49, No. 8, pages 415-418, 1966, whose disclosures are incorporated by reference. The use of the purified precursor material of the invention with any of these or other known techniques results in significantly improved crystals as compared with those previously obtainable.

The crystals of KNb₁₋ₓTaₓO₃ are generally similar to those using unpurified precursor powder material in physical appearance, shape, and crystallographic orientation. However, their properties of interest, such as the electrical and optical properties, are significantly improved over those available previously. The crystals of the invention are usually nearly colorless, due to the removal of color centers in the purification process of the precursor powder.

The following examples will serve to illustrate aspects of the invention, but should not be taken as limiting the invention in any respect.

The best oxide powders available commercially in large lots were obtained from Johnson Matthey Company or Morton Thiokol Co., both of which supply powder represented to be of the highest purity available, but which has at least 200 parts per million total impurity content. The impurity content of the as-received materials is reported in Table I. In this and the following table, the notation "<" means "less than" and impurity contents are in parts per million (atomic).

**Table I**

| Impurity | Starting Powder | |
|---|---|---|
| | Nb₂O₅ | Ta₂O₅ |
| Na | 0.4 | 0.06 |
| Mg | 47 | - |
| Al | 9 | 1.7 |
| Si | 10-280 | 150-4300 |
| Ti | 32 | 7 |
| Cr | 0.8 | 3 |
| Fe | 230-330 | 44-230 |
| Ni | 12 | 20 |
| Cu | 10 | 10 |
| F | < .001 | < .0001 |
| Cl | 1600 | 2200 |
| Ca | 9 | 1.3 |
| Sr | < .01 | < .01 |
| Ba | 0.2 | - |
| In | 0.5 | 0.03 |
| K | 12 | 0.02 |
| Mn | 4.3 | 1.5 |

These high impurity levels are damaging to the final properties of the KNb₁₋ₓTaₓO₃ crystals grown from such starting materials. The total impurity levels are well over 200 parts per million, and, if retained through the final crystal, would interfere substantially with its performance.

These powders were then purified according to the preferred procedure of the invention and grown into crystals by the technique described previously. The chemical analyses of four representative crystals are reported in the following Table II.

**Table II**

| Impurity | Tantalum Content | | | |
|---|---|---|---|---|
| | .42 | .42 | .40 | .40 |
| Na | - | - | .06 | .06 |
| Al | 0.8 | 0.6 | .02 | .05 |
| Si | 3.6 | 2.6 | 1.7 | - |
| Cl | .03 | - | 2.5 | - |
| Fe | 3 | 0.8 | 0.1 | - |
| Ni | 1.4 | 1.2 | 0.1 | - |
| Cu | - | 0.14 | 0.2 | - |
| Si | - | - | 0.01 | .38 |
| Rh | 0.4 | 1.7 | 0.03 | 0.3 |
| Ba | 0.7 | 0.02 | 0.08 | .003 |
| Ca | <8 | <7 | .0004 | .02 |
| Ce | - | - | .0004 | - |
| Nd | - | - | .001 | - |
| Gd | - | - | .005 | .0004 |
| Yb | - | - | .0006 | - |
| Mg | 0.3 | 0.2 | - | .16 |
| F | 4 | 5 | - | - |
| Cr | 0.6 | 0.04 | - | - |
| Sr | 0.07 | 0.5 | - | - |
| Zr | <1 | 0.09 | - | - |

The crystals whose compositions are reported in Table II have the general composition KNb₁₋ₓTaₓO₃, and the x value or Ta content is stated at the heading of each column. As in Table I, a dash (-) indicates that the measured level was below the sensitivity of the instrument.

A comparison of the chemical composition results in Table I (as-received material) and Table II (final crystals) illustrates the major reduction in impurity content accomplished by the present purification process. This reduced impurity content of metallic and halide species results in improved performance of the crystals, and has not been previously available. It is believed that crystals of KNb₁₋ₓTaₓO₃ having total metal and halide content less than 100 parts per million (atomic), and also below 50 parts per million (atomic), and also below 15 parts per million (atomic), all of which are possible using the approach of the present invention, have been previously unknown.

It will therefore be appreciated that the process of the invention yields higher purity oxides of the form (Nb₁₋ₓTaₓ)₂O₅ than otherwise available, which in turn can be used to produce crystals of the form KNb₁₋ₓTaₓO₃ having higher purity and better electrical properties than heretofore possible. The process of the invention utilizes commonly available apparatus and a commonly available, inexpensive gaseous reactant, water. The purification process is physically and chemically safe to operate, requires only a single step rather than multiple purification steps, needs only minimal attention during extended purification runs, and does not require complex scrubbers to process the residue.

## Claims

1. A process for purifying oxides of the form (Nb₁₋ₓTaₓ)₂O₅, where x ranges from O to 1, by removing nearly all impurities including the most harmful metallic and halide impurities, comprising the steps of:
furnishing the (Nb₁₋ₓTaₓ)₂O₅ in a finely divided form; heating the finely divided (Nb₁₋ₓTaₓ)₂O₅ to a temperature of at least 600° C; and
passing water vapor over the heated, finely divided (Nb₁₋ₓTaₓ)₂O₅, thereby removing impurities therefrom.

2. The process of claim 1, wherein the water vapor is transported in a mixture with a carrier gas.

3. The process of claim 2, wherein the carrier gas is nitrogen.

4. The process of claim 2 and/or 3, wherein the water vapor is introduced into the carrier gas by bubbling the carrier gas through a water container, wherupon the water vapor mixes with the carrier gas.

5. The process of any of claims 1-4, wherein the temperature of the (Nb₁₋ₓTaₓ)₂O₅ during said step of passing is from about 900° C to about 1100° C.

6. The process of any of claims 1-5, wherein x is 0, so that the oxide is Nb₂O₅.

7. The process of any of claims 1-5, wherein x is 1, so that the oxide is Ta₂O₅.

8. The process of any of claims 1-7, wherein the (Nb₁₋ₓTaₓ)₂O₅ is contained within a quartz tube during said step of passing.

9. The process of any of claims 5 to 8, comprising the steps of:
placing the (Nb₁₋ₓTaₓ)₂O₅ into a container in a tube;
heating the finely divided (Nb₁₋ₓTaₓ)₂O₅ to a temperature of from about 900° C to about 1100° C; and
passing a mixture of water vapor in a carrier gas through the tube and over the (Nb₁₋ₓTaₓ)₂O₅, thereby removing impurities from the (Nb₁₋ₓTaₓ)₂O₅.

10. The process of claim 9, wherein said step of passing is continued for a period of about 14 days.

11. The process of claim 9 and/or 10, wherein the temperature of the (Nb₁₋ₓTaₓ)₂O₅ during said step of passing is about 1000° C.

12. A process for preparing highly pure crystals of KNb₁₋ₓTaₓO₃, where x ranges from 0 to 1, comprising the steps of:
furnishing finely divided (Nb₁₋ₓTaₓ)₂O₅ obtained according to the process of any of claims 1 to 11 and having an impurity content of less than about 100 parts per million;
placing the (Nb₁₋ₓTaₓ)₂O₅ into a crucible, adding potassium carbonate, and melting the composition of finely divided powder plus potassium carbonate for producing a melt of KNb₁₋ₓTaₓO₃;
touching a seed crystal to the surface of the melt; and
withdrawing the seed crystal upwardly to form a highly pure crystal of KNb₁₋ₓTaₓO₃ thereupon.

13. A high purity KNb₁₋ₓTaₓO₃ material, comprising KNb₁₋ₓTaₓO₃ having an impurity content of less than about 100 parts per million, where x ranges from 0 to 1, inclusive, obtainable according to the process of claim 12.

14. The material of claim 13, wherein the impurity content is less than about 15 parts per million.

## Patentansprüche

1. Ein Verfahren zur Reinigung von Oxiden in der Form (Nb₁₋ₓTaₓ)₂O₅, wobei x von 0 bis 1 reicht, durch Entfernen nahezu aller Verunreinigungen, einschließlich der höchst schädlichen metallischen und Halogenid-Verunreinigungen, welches die folgenden Schritte umfaßt:
(Nb₁₋ₓTaₓ)₂O₅ wird in einer fein verteilten Form bereitgestellt,
das fein verteilte (Nb₁₋ₓTaₓ)₂O₅ wird auf eine Temperatur von wenigstens 600°C erhitzt und
Wasserdampf wird über das erhitzte, fein verteilte (Nb₁₋ₓTaₓ)₂O₅ geleitet und dadurch werden die Verunreinigungen daraus entfernt.

2. Das Verfahren nach Anspruch 1, wobei der Wasserdampf in einer Mischung mit einem Fördergas transportiert wird.

3. Das Verfahren nach Anspruch 2, wobei das Fördergas Stickstoff ist.

4. Das Verfahren nach Anspruch 2 und/oder 3, wobei der Wasserdampf durch Blasen des Fördergases durch einen Wasserbehälter in das Fördergas eingeführt wird, woraufhin sich der Wasserdampf mit dem Fördergas mischt.

5. Das Verfahren nach einem der Ansprüche 1-4, wobei die Temperatur des (Nb₁₋ₓTaₓ)₂O₅ während des genannten Schrittes des Überleitens ca. 900°C bis ca. 1100°C beträgt.

6. Das Verfahren nach einem der Ansprüche 1-5, wobei x gleich 0 ist, so daß das Oxid Nb₂O₅ ist.

7. Das Verfahren nach einem der Ansprüche 1-5, wobei x gleich 1 ist, so daß das Oxid Ta₂O₅ ist.

8. Das Verfahren nach einem der Ansprüche 1-7, wobei das (Nb₁₋ₓTaₓ)₂O₅ während des genannten Schrittes des Überleitens in einem Quarzrohr enthalten ist.

9. Das Verfahren nach einem der Ansprüche 5-8, welches die folgenden Schritte umfaßt:
Das (Nb₁₋ₓTaₓ)₂O₅ wird in einen Behälter in einem Rohr eingebracht,
das fein verteilte (Nb₁₋ₓTaₓ)₂O₅ wird auf eine Temperatur von ca. 900°C bis ca. 1100°C erhitzt und
eine Mischung aus Wasserdampf in einem Fördergas wird durch das Rohr und über das (Nb₁₋ₓTaₓ)₂O₅ geleitet und dadurch werden die Verunreinigungen aus dem (Nb₁₋ₓTaₓ)₂O₅ entfernt.

10. Das Verfahren nach Anspruch 9, wobei der genannte Schritt des Überleitens über einen Zeitraum von ca. 14 Tagen fortgesetzt wird.

11. Das Verfahren nach Anspruch 9 und/oder 10, wobei die Temperatur des (Nb₁₋ₓTaₓ)₂O₅ während des genannten Schrittes des Überleitens ca. 1000°C beträgt.

12. Ein Verfahren zur Herstellung von hochreinen Kristallen von KNb₁₋ₓTaₓO₃, wobei x von 0 bis 1 reicht, welches die folgenden Schritte umfaßt:
Fein verteiltes (Nb₁₋ₓTaₓ)₂O₅, welches gemäß dem Verfahren nach einem der Ansprüche 1 bis 11 erhalten wurde und einen Gehalt an Verunreinigungen von weniger als ca. 100 ppm hat wird bereitgestellt,
das (Nb₁₋ₓTaₓ)₂O₅ wird in einen Tiegel eingebracht, Kaliumcarbonat wird zugegeben und die Mischung von fein verteiltem Pulver plus Kaliumcarbonat wird geschmolzen, um eine Schmelze aus KNb₁₋ₓTaₓO₃ herzustellen,
ein Impfkristall wird mit der Oberfläche der Schmelze in Berührung gebracht und
der Impfkristall wird nach oben zurückgezogen, um darauf einen hochreinen Kristall von KNb₁₋ₓTaₓO₃ zu formen.

13. Ein hochreines KNb₁₋ₓTaₓO₃-Material, welches KNb₁₋ₓTaₓO₃ mit einem Gehalt an Verunreinigungen von weniger als ca. 100 ppm enthält, wobei x von 0 bis 1 reicht (inklusive), welches gemäß dem Verfahren nach Anspruch 12 erhältlich ist.

14. Das Material nach Anspruch 13, wobei der Gehalt an Verunreinigungen kleiner als ca. 15 ppm ist.

## Revendications

1. Procédé de purification d'oxydes de la forme (Nb₁₋ₓTaₓ)₂O₅, dans lequel x a une valeur de 0 à 1, par élimination de la quasi-totalité des impuretés comportant les impuretés métalliques et du type d'halogénurses les plus nuisibles, qui comprend les étapes consistant :
à amener le (Nb₁₋ₓTaₓ)₂O₅ à une forme finement divisée ;
à chauffer le (Nb₁₋ₓTaₓ)₂O₅ finement divisé jusqu'à une température d'au moins 600°C ; et
à faire passer de la vapeur d'eau sur le (Nb₁₋ₓTaₓ)₂O₅ finement divisé et chauffé, de manière à en éliminer les impuretés.

2. Procédé suivant la revendication 1, dans lequel la vapeur d'eau est transportée en mélange avec un gaz d'entraînement.

3. Procédé suivant la revendication 2, dans lequel le gaz d'entraînement est l'azote.

4. Procédé suivant la revendication 2 et/ou la revendication 3, dans lequel la vapeur d'eau est introduite dans le gaz d'entraînement par barbotage de ce gaz dans un récipient contenant de l'eau, en sorte que la vapeur d'eau se mélange au gaz d'entraînement.

5. Procédé suivant l'une quelconque des revendications 1 à 4, dans lequel la température du (Nb₁₋ₓTaₓ)₂O₅ pendant cette étape de passage va d'environ 900°C à environ 1100°C.

6. Procédé suivant l'une quelconque des revendications 1 à 5, dans lequel x est égal à 0, l'oxyde étant donc Nb₂O₅.

7. Procédé suivant l'une quelconque des revendications 1 à 5, dans lequel x est égal à 1, l'oxyde étant donc Ta₂O₅.

8. Procédé suivant l'une quelconque des revendications 1 à 7, dans lequel le (Nb₁₋ₓTaₓ)₂O₅ est contenu dans un tube de quartz pendant l'étape de passage.

9. Procédé suivant l'une quelconque des revendications 5 à 8, qui comprend les étapes consistant :
à introduire le (Nb₁₋ₓTaₓ)₂O₅ dans un récipient contenu dans un tube ;
à chauffer le (Nb₁₋ₓTaₓ)₂O₅ finement divisé jusqu'à une température d'environ 900°C à environ 1100°C ; et
à faire passer un mélange de vapeur d'eau dans un gaz d'entraînement à travers le tube et sur le (Nb₁₋ₓTaₓ)₂O₅, de manière à éliminer les impuretés du (Nb₁₋ₓTaₓ)₂O₅.

10. Procédé suivant la revendication 9, dans lequel l'étape de passage est poursuivie pendant une période d'environ 14 jours.

11. Procédé suivant la revendication 9 et/ou la revendication 10, dans lequel la température du (Nb₁₋ₓTaₓ)₂O₅ pendant cette étape de passage est d'environ 1000°C.

12. Procédé de préparation de cristaux de grande pureté de KNb₁₋ₓTaₓO₃, où x a une valeur de 0 à 1, qui comprend les étapes consistant :
à prendre du (Nb₁₋ₓTaₓ)₂O₅ finement divisé obtenu conformément au procédé suivant l'une quelconque des revendications 1 à 11 et ayant une teneur en impuretés de moins d'environ 100 parties par million ;
à mettre en place le (Nb₁₋ₓTaₓ)₂O₅ dans un creuset, à ajouter du carbonate de potassium et à faire fondre la composition de poudre finement divisée additionnée de carbonate de potassium pour la production d'une masse fondue de KNb₁₋ₓTaₓO₃ ;
à mettre un germe cristallin en contact avec la surface de la masse fondue ; et
à enlever le germe cristallin en le tirant vers le haut pour former ensuite un cristal très pur de KNb₁₋ₓTaₓO₃.

13. Matière formée de KNb₁₋ₓTaₓO₃ de grande pureté comprenant du KNb₁₋ₓTaₓO₃ ayant une teneur en impuretés de moins d'environ 100 parties par million, X ayant une valeur de 0 à 1 inclus, pouvant être obtenue conformément au procédé de la revendication 12.

14. Matière suivant la revendication 13, dont la teneur en impuretés est inférieure à environ 15 parties par million.
